Europäisches Patentamt

(19) European Patent Office

Office européen des brevets

(11) Numéro de publication: **0 161 973**
**B1**

(12) **FASCICULE DE BREVET EUROPEEN**

(51) Int. Cl.⁴: **H 03 K 3/288,** H 03 M 1/36

(45) Date de publication du fascicule du brevet:
**19.11.87**

(21) Numéro de dépôt: **85400785.3**

(22) Date de dépôt: **19.04.85**

(54) Perfectionnement aux comparateurs avec circuit de verrouillage et convertisseur analogique numérique utilisant de tels comparateurs.

(30) Priorité: **19.04.84 FR 8406216**

(43) Date de publication de la demande:
**21.11.85 Bulletin 85/47**

(45) Mention de la délivrance du brevet:
**19.11.87 Bulletin 87/47**

(84) Etats contractants désignés:
**DE FR GB IT NL**

(56) Documents cités:
**FR - A - 2 341 231
US - A - 3 821 719
US - A - 3 904 895**

(73) Titulaire: **THOMSON-CSF, 173, Boulevard Haussmann,
F-75379 Paris Cédex 08 (FR)**

(72) Inventeur: **Mourey, Michel, THOMSON-CSF
SCPI 173, Bld Haussmann, F-75379 Paris Cedex 08 (FR)**
Inventeur: **van Zanten, François, THOMSON-CSF
SCPI 173, Bld Haussmann, F-75379 Paris Cedex 08 (FR)**

(74) Mandataire: **Ruellan-Lemonnier, Brigitte et al,
THOMSON-CSF SCPI 19, avenue de Messine,
F-75008 Paris (FR)**

ACTORUM AG

## Description

La présente invention concerne les comparateurs avec circuit de verrouillage destinés à comparer une tension analogique à une tension de référence et plus particulièrement un perfectionnement au circuit de verrouillage.

La présente invention concerne aussi l'application de ces comparateurs à circuit de verrouillage à un convertisseur analogique-numérique rapide à structure parallèle.

On décrira donc la présente invention en se référant à un tel convertisseur. De manière connue, un convertisseur analogique-numérique rapide de n bits comporte $2^n-1$ comparateurs de tension définissant les $2^n$ niveaux élémentaires par lesquels est quantifié le signal analogique d'entrée.

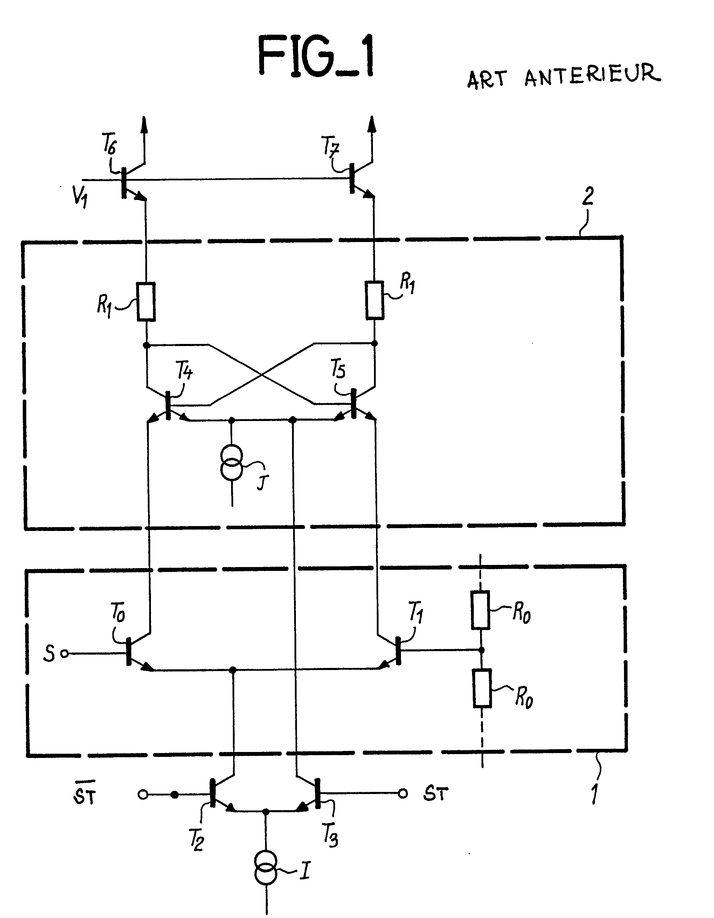

On a représenté sur la figure 1 un mode de réalisation d'un comparateur de l'art antérieur réalisé en technologie bipolaire et utilisé, par exemple, dans un convertisseur analogique-numérique de n bits, comparateur auquel s'applique la présente invention.

Ce comparateur est constitué principalement par un circuit de comparaison 1 formé des transistors $T_0$ et $T_1$ montés en étage différentiel et par un circuit de verrouillage 2 formé des transistors $T_4$ et $T_5$ montés en bascule bistable à rebouclage direct. De manière plus spécifique, les transistors $T_4$ et $T_5$ sont des transistors à deux émetteurs. L'un des émetteurs de chaque transistor $T_4$, $T_5$ est relié respectivement au collecteur des transistors $T_0$, $T_1$ dont les émetteurs sont reliés ensemble et dont les bases reçoivent respectivement la tension analogique à comparer et la tension de référence, comme cela sera expliqué de manière plus détaillée ci-après.

Les deux autres émetteurs des transistors $T_4$, $T_5$ sont reliés ensemble. De plus, la base de chaque transistor $T_4$, $T_5$ est connectée respectivement au collecteur de l'autre transistor $T_5$, $T_4$ de manière à former la bascule bistable. Le courant disponible pour les paires de transistors $T_0$, $T_1$ et $T_4$, $T_5$ est fourni par la source de courant I et est aiguillé vers l'une ou l'autre paire par l'intermédiaire d'un circuit de commutation constitué des deux transistors $T_2$, $T_3$ couplés par leurs émetteurs de manière à former un étage différentiel. Pour réaliser l'aiguillage du courant vers l'une ou l'autre paire de transistors $T_0$, $T_1$ et $T_4$, $T_5$, les transistors $T_2$, $T_3$ reçoivent sur leur base une tension de commande ST dont le signe s'inverse. D'autre part, pour obtenir une petite quantité d'hystérésis déterminée de manière à minimiser l'erreur introduite par les oscillations à bas niveau et le bruit, tout en donnant une résolution satisfaisante, une source de courant J est connectée aux émetteurs des transistors $T_4$, $T_5$.

Ainsi, le circuit de comparaison lorsqu'il est utilisé dans un convertisseur analogique-numérique de n bits reçoit d'une part sur la base du transistor $T_0$ le signal analogique à convertir en une valeur numérique binaire de n bits et d'autre part, sur la base du transistor $T_1$, une tension de référence qui est une fraction, exprimée en multiples de $1/2^n$, d'une tension de référence générale. La tension de référence est établie, dans le mode de réalisation représenté, à l'aide d'un pont diviseur résistif de grande précision, formé de $2^n$ résistances en série, de valeur commune $R_0$ et alimenté par la tension de référence globale. Une prise intermédiaire est prévue entre deux résistances $R_0$ en fonction du rang du comparateur dans le convertisseur. Cette prise est reliée à la base du transistor $T_1$ pour lui amener une tension de référence correspondante qui est une fraction, multiple de $1/2^n$, de la tension de référence globale.

Les sorties de la bascule bistable formée par les transistors $T_4$, $T_5$ fournissent aux bornes des résistances de charge $R_1$, un niveau logique binaire indiquant si le signal analogique est supérieur ou inférieur à la tension de référence.

Les sorties de la bascule bistable sont appliquées par l'intermédiaire de transistors $T_6$, $T_7$ montés en portes logiques vers un circuit logique d'encodage de type connu qui n'a pas été représenté sur la figure 1 et qui fournit un mot de n bits représentatif du signal analogique.

Pour réaliser un convertisseur analogique-numérique de n bits, on associe en parallèle $2^n-1$ comparateurs du type ci-dessus.

Les convertisseurs réalisés avec ce type de comparateurs sont des convertisseurs grande vitesse qui présentent l'avantage d'avoir une faible consommation et de pouvoir être réalisés sous forme de circuits intégrés sur une surface relativement faible.

En effet, lorsque le circuit de verrouillage est constitué par une bascule bistable, comme représenté sur la figure 1, on réalise une économie de courant puisque seule la source de courant I est nécessaire pour commander les deux circuits du comparateur. Toutefois, il est alors nécessaire de contrôler très soigneusement la chute de tension dans les résistances de charge $R_1$.

Si $R_1$ est trop élevée, il y a saturation des transistors $T_4$ ou $T_5$ et si $R_1$ est trop faible, on obtient un taux de réaction insuffisant pour mémoriser un faible déséquilibre de courant correspondant à un faible écart de tensions d'entrée.

D'autre part, la possibilité de variation de tension admissible avant saturation est réduite par le comportement logarithmique des jonctions base-émetteur des transistors $T_6$ et $T_7$. En effet, quand l'un des transistors, par exemple le transistor $T_4$, de la bascule est bloqué, l'émetteur de $T_6$ est parcouru par le courant de base de $T_5$ alors que l'émetteur de $T_7$ est parcouru par le courant collecteur de $T_5$ d'où une différence de tension de

$$\frac{k\,T}{q}\ \text{Log}\ \#\ 125\,\text{mV}$$

où : $\dfrac{k\,T}{q}$ représente le potentiel thermodynamique et $\beta$ le gain en courant des transistors.

Cette différence de tension doit être déduite de la dynamique sur le circuit de verrouillage.

En conséquence, on constate que la dynamique admissible ne peut dépasser environ 350 mV à la température ambiante et encore moins aux températures plus élevées si l'on veut éviter la saturation. En fait, il n'est pas possible, avec les circuits de verrouillage à rebouclage direct de l'art antérieur, d'avoir à la fois un taux de réaction suffisamment fort et une dynamique suffisamment faible pour éviter la saturation quelle que soit la température.

La présente invention a donc pour but de remédier aux inconvénients ci-dessus dans les comparateurs à circuit de verrouillage à rebouclage direct.

En conséquence, la présente invention a pour objet un comparateur avec circuit de verrouillage réalisé en technologie bipolaire et comportant au moins un circuit de comparaison et un circuit de verrouillage constitué par au moins deux transistors montés en bascule bistable à rebouclage direct dont chacune des sorties est reliée à une résistance de charge et à un transistor de liaison, caractérisé en ce qu'il comporte de plus un circuit antisaturation monté en parallèle sur chaque ensemble résistance de charge-transistor de liaison, et un circuit de polarisation fournissant entre la base du transistor de liaison et le circuit antisaturation correspondant une différence de potentiel évitant la saturation des transistors montés en bascule bistable.

Selon un mode de réalisation préférentiel, le circuit antisaturation est constitué par un transistor bipolaire dont le collecteur est relié au collecteur du transistor de liaison, la base au circuit de polarisation et l'émetteur à une des sorties de la bascule.

D'autre part, le circuit de polarisation est constitué, de préférence, par un circuit de simulation reproduisant la partie conductrice du circuit de verrouillage muni du circuit antisaturation auquel est appliquée la différence de potentiel évitant la saturation et dont le transistor formant la moitié de la bascule bistable est polarisé, à travers un transistor intermédiaire identique, par une source de courant de valeur égale à la source de courant polarisant le circuit de verrouillage du comparateur. De plus, le courant base du transistor formant la moitié de la bascule bistable choisi pour maintenir ledit transistor juste en début de saturation ou hors saturation est comparé, après passage dans un miroir de courant, au courant de base de ce transistor intermédiaire, toute différence de courant créant une variation de tension envoyée sur un étage différentiel donnant en sortie la différence de potentiel évitant la saturation pour rééquilibrer le courant de base du transistor formant la moitié de la bascule bistable.

D'autres caractéristiques et avantages de la présente invention apparaîtront à la lecture de la description d'un mode de réalisation préférentiel faite avec référence aux dessins ci-annexés dans lesquels:

— la figure 1, déjà décrite, est un schéma électrique d'un comparateur de l'art antérieur, et

— la figure 2 est un schéma électrique partiel d'un convertisseur analogique-numérique comprenant des comparateurs et un circuit de polarisation conformes à la présente invention.

Sur les différentes figures, les mêmes références désignent les mêmes éléments.

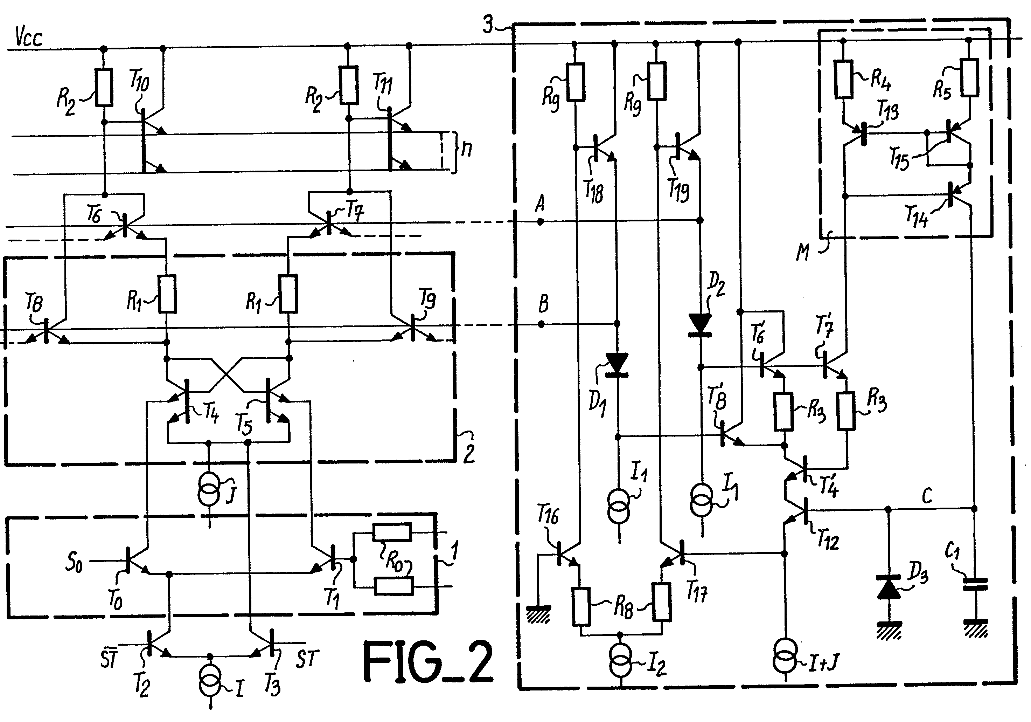

Sur la figure 2, on a représenté notamment un étage comparateur d'un convertisseur analogique-numérique rapide à structure parallèle. L'étage comparateur représenté comporte un circuit de comparaison 1 et un circuit de verrouillage 2 identiques aux circuits de comparaison et de verrouillage du comparateur de la figure 1. En conséquence, ces circuits ne seront pas redécrits.

D'autre part, on a représenté sur la figure 2, un mode de réalisation de la partie codage qui peut être associée avec le comparateur. En fait, puisque les différents étages comparateurs sont montés en parallèle, les transistors de liaison $T_6$, $T_7$ montés en porte logique sont des transistors à deux émetteurs, l'un des émetteurs étant connecté respectivement à une sortie de la bascule bistable et l'autre émetteur étant connecté à une sortie du comparateur précédent pour le transistor $T_6$ et à une sortie du comparateur suivant pour le transistor $T_7$. Ces connexions sont représentées par des tirets sur la figure 2. Les collecteurs des transistors $T_6$ et $T_7$ sont reliés respectivement à une source de tension positive $V_{cc}$ par l'intermédiaire d'une résistance de charge $R_2$ et à la base des transistors de sortie $T_{10}$ et $T_{11}$ montés en collecteur commun. Les transistors $T_{10}$ et $T_{11}$ sont des transistors à émetteurs multiples. Les émetteurs sont reliés à n lignes de sortie correspondant aux bits quantifiés du mot de donnée que représente les transistors $T_{10}$ et $T_{11}$.

Conformément à la présente invention, un circuit antisaturation est monté en parallèle sur chaque ensemble résistance de charge-transistor de liaison. Selon le mode de réalisation représenté à la figure 2, ce circuit antisaturation est constitué par un transistor bipolaire $T_8$, $T_9$ respectivement à deux émetteurs qui sert à contrôler le potentiel bas sur les collecteurs de $T_4$, $T_5$ respectivement et ainsi à les maintenir en dehors de la zone de saturation. De manière plus spécifique, le collecteur du transistor $T_8$ est connecté au collecteur du transistor $T_6$, un de ses émetteurs étant connecté au collecteur du transistor $T_4$ et l'autre émetteur étant connecté à une sortie du comparateur précédent. De même, le collecteur du transistor $T_9$ est connecté au collecteur du transistor $T_7$, un de ses émetteurs étant connecté au collecteur du transistor $T_5$ et l'autre émetteur étant connecté à une sortie du comparateur suivant. Une différence de potentiel $V_A$-$V_B$ permettant d'éviter la saturation des transistors $T_4$ ou $T_5$, comme cela sera expliqué ci-après, est appliquée entre les bases reliées ensemble des transistors $T_6$ et $T_7$ et les bases reliées ensemble des transistors $T_8$ et $T_9$. Cette différence de potentiel est obtenue en sortie d'un circuit de polarisation 3 qui, dans le mode de réalisation représenté, est commun à tous les comparateurs.

Le circuit de polarisation 3 représenté comporte principalement un circuit simulant la partie conductrice du circuit de verrouillage. Le circuit de simulation est constitué des transistors $T'_4$, $T'_6$, $T'_7$, $T'_8$ qui sont rigoureusement identiques aux transistors $T_4$, $T_6$, $T_7$, $T_8$ et connectés de la même manière pour obtenir cette partie conductrice. La partie comportant des transistors bloqués n'intervient pas dans le fonctionnement et n'est donc pas reproduite.

Le circuit de simulation est chargé par les deux résistances $R_3$ qui sont égales à $\varepsilon R_1$ avec $\varepsilon \# 1$ et > 1. D'autre part, le circuit de simulation est connecté par l'intermédiaire du transistor $T_{12}$ identique au transistor $T_4$ à la source de courant I + J qui est elle-même égale aux sources de courant I et J polarisant les étages comparateurs.

D'autre part, les bases des transistors $T'_6$ et $T'_7$ reliées ensemble et la base du transistor $T'_8$ sont

reliées respectivement aux points A et B par l'intermédiaire des diodes $D_2$ et $D_1$ qui assurent une simple translation de niveau. En conséquence, la tension $V_A$-$V_B$ appliquée entre les bases des transistors $T_6$, $T_7$ et les bases des transistors $T_8$, $T_9$ est aussi appliquée entre les bases des transistors $T'_6$ et $T'_7$ et la base du transistor $T'_8$.

De plus le collecteur de $T'_7$ est relié à un miroir de courant M dont la sortie est connectée à la base du transistor $T_{12}$. Ce miroir de courant est constitué de manière connue par des transistors PNP 13, 14, 15 lorsque les autres transistors sont des transistors NPN comme dans le mode de réalisation représenté.

De manière plus spécifique, la base du transistor $T_{14}$ est reliée au collecteur du transistor $T_{13}$ lui-même relié au collecteur de $T'_7$. L'émetteur de $T_{14}$ est connecté au collecteur de $T_{15}$. De plus le collecteur de $T_{14}$ est relié à la base de $T_{12}$ et l'émetteur de $T_{13}$ est relié par l'intermédiaire d'une résistance de charge $R_4$ à la tension de polarisation $V_{cc}$.

D'autre part, la base de $T_{13}$ est reliée à la base et au collecteur de $T_{15}$ dont l'émetteur est relié par l'intermédiaire d'une résistance de charge $R_5$ à la tension de polarisation $V_{CC}$. Le gain k du miroir de courant est choisi inférieur à 1, comme cela sera expliqué ci-après. Pour s'affranchir des écarts sur les gains en courant et l'imprécision du miroir, on prend de préférence $k = 1/2$.

D'autre part, l'émetteur de $T_{12}$ est relié à une entrée d'un étage différentiel constitué par les transistors $T_{16}$ et $T_{17}$ couplés par leurs émetteurs et alimentés par la source de courant $I_2$. L'autre entrée de l'étage différentiel, à savoir la base de $T_{16}$, est reliée à la masse. De plus, des résistances de contre réaction $R_8$ sont prévues en série avec les émetteurs des transistors de l'étage différentiel pour assurer la stabilité du circuit de polarisation.

Chaque sortie de l'étage différentiel, à savoir les collecteurs de $T_{16}$ et $T_{17}$, est reliée respectivement à la tension $V_{CC}$ par l'intermédiaire d'une résistance de charge $R_9$ et à la base d'un des transistors $T_{18}$, $T_{19}$ dont les collecteurs sont reliés à la tension $V_{CC}$ et dont les émetteurs sont connectés respectivement aux points B et A.

De plus, des sources de courant $I_1$ polarisent les transistors $T_{18}$, $T_{19}$ et les diodes $D_1$ et $D_2$ avec des courants déterminés et égaux pour qu'il n'y ait pas d'écart dans les chutes de tension.

D'autre part, pour faciliter la mise en marche du circuit de polarisation et éviter un verrouillage intempestif de l'ensemble, une diode $D_3$ est connectée entre la masse et la base du transistor $T_{12}$. Cette diode $D_3$ est bloquée en fonctionnement normal. De plus, une capacité C est aussi prévue entre la base du transistor $T_{12}$ et la masse pour fixer le pôle dominant du circuit de polarisation.

On expliquera maintenant de manière plus détaillée le fonctionnement des circuits décrits ci-dessus.

Pour engendrer une différence de potentiel $V_A$-$V_B$ suffisante pour éviter la saturation des transistors $T_4$ ou $T_5$ des circuits de verrouillage, on choisit pour $T'_4$ un courant de base juste suffisant pour que $T'_4$ entre en saturation et on effectue la comparaison des courants de base des transistors identiques $T'_4$ et $T_{12}$.

En fait, avec le circuit décrit ci-dessus, les transistors $T'_4$ et $T_{12}$ sont parcourus par le même courant $I+J$ (on suppose que le gain en courant en base commune $\alpha \# 1$).

Le courant de base de $T_{12}$ est donc $\dfrac{I+J}{\beta}$ avec $\beta$ le gain en courant de $T_{12}$.

D'autre part, le courant de base de $T'_4$ est recopié par l'intermédiaire de $T'_7$ dans le miroir M de gain $k < 1$.

Si les deux courants de base ne sont pas dans le rapport k, il y a variation de la tension au point C. Cette variation est transmise sur la base de $T_{17}$, par l'intermédiaire de $T_{12}$, ce qui crée une tension différentielle aux bornes des résistances $R_9$ par l'intermédiaire de l'étage différentiel $T_{16}$, $T_{17}$, $I_2$. Cette tension différentielle est recopiée par les transistors à émetteurs suiveurs $T_{18}$, $T_{19}$ et modifie la différence de potentiel $V_B$-$V_A$ qui polarise les $2^n$-1 circuits de verrouillage.

Ainsi, un courant de base de $T'_4$ trop élevé, à savoir un courant de base mettant $T'_4$ en saturation, fait croître le potentiel en C. Il en résulte une décroissance du potentiel de A et une croissance du potentiel de B. Le transistor $T'_8$ fournit alors du courant au collecteur de $T'_4$ qui devient non saturé. Le courant de base de $T'_4$ diminue alors, ce qui rétablit l'équilibre.

Cet équilibre s'établit à un niveau déterminé par le gain k du miroir M. En effet, le degré de saturation de $T'_4$ est tel que

$$\frac{\beta}{\beta \text{ forcé } T'_4} = \frac{I_C/I_B (T_{12})}{I_C/I_B (T'_4)} = \frac{I_B (T'_4)}{I_B (T_{12})} = \frac{1}{k}$$

On pourrait donc prendre k tout juste inférieur à 1. Toutefois, comme mentionné ci-dessus, on choisit de préférence $k = 1/2$.

Ainsi le degré de saturation de $T'_4$ est tel que

$$\frac{\beta I_B}{I_C} = \frac{1}{k} = 2$$

c'est-à-dire que le courant de base de $T'_4$ est égal à deux fois le courant de base d'un transistor non saturé, à savoir $T_{12}$, parcouru par le même courant, ce qui correspond à une légère saturation pour $T'_4$.

D'autre part, pour que les transistors $T_4$ et $T_5$ des circuits de verrouillage ne stockent qu'une charge négligeable, les résistances $R_3$ sont légèrement supérieures aux résistances $R_1$, comme déjà mentionné.

Ainsi avec le circuit de polarisation décrit ci-dessus, il est possible d'obtenir entre A et B une différence de potentiel $V_A$-$V_B$ qui prend en compte les variations de température et toutes les dispersions possibles affectant la fabrication puisque le circuit de polarisation est réalisé sur le même substrat que le convertisseur avec des éléments identiques.

## Revendications

1. Un comparateur avec circuit de verrouillage réalisé en technologie bipolaire et comportant au moins un circuit de comparaison (1) et un circuit de verrouillage (2) constitué par au moins deux transistors ($T_4$, $T_5$) montés en bascule bistable à rebouclage direct dont chacune des sorties est reliée à une résistance de charge ($R_1$) et à un transistor de liaison ($T_6$, $T_7$), caractérisé en ce qu'il comporte de plus un circuit antisaturation ($T_8$, $T_9$) monté en parallèle sur chaque ensemble résistance de charge-transistor de liaison, et un circuit de polarisation (3) fournissant entre la base du transistor de liaison ($T_6$, $T_7$) et le circuit antisaturation ($T_8$, $T_9$) correspondant une différence de potentiel évitant la saturation des transistors ($T_4$, $T_5$) montés en bascule bistable.

2. Un comparateur avec circuit de verrouillage selon la revendication 1, caractérisé en ce que le circuit antisaturation est constitué par un transistor bipolaire ($T_8$, $T_9$) dont le collecteur est relié au collecteur du transistor de liaison, la base au circuit de polarisation et l'émetteur à une des sorties de la bascule.

3. Un comparateur avec circuit de verrouillage selon l'une quelconque des revendications 1 et 2, caractérisé en ce que le circuit de polarisation (3) est constitué par un circuit de simulation ($T'_4$, $T'_8$, $T'_6$, $T'_7$) reproduisant la partie conductrice du circuit de verrouillage muni du circuit antisaturation auquel est appliquée la différence de potentiel évitant la saturation et dont le transistor formant la moitié de la bascule bistable est polarisé à travers un transistor intermédiaire ($T_{12}$) identique par une source de courant (I + J) de valeur égale à la source de courant polarisant le circuit de verrouillage du comparateur et en ce que le courant base du transistor ($T'_4$) formant la moitié de la bascule bistable choisi pour maintenir ledit transistor juste en début de saturation ou hors saturation est comparé, après passage dans un miroir de courant (M) au courant de base du transistor intermédiaire ($T_{12}$), toute différence de courant créant une variation de tension envoyée sur un étage différentiel donnant en sortie ladite différence de potentiel évitant la saturation pour rééquilibrer le courant de base du transistor ($T'_4$) formant la moitié de la bascule bistable.

4. Un comparateur avec circuit de verrouillage suivant la revendication 3, caractérisé en ce que le miroir de courant (M) présente un gain k inférieur à 1.

5. Un comparateur avec circuit de verrouillage suivant la revendication 4, caractérisé en ce que le gain k est choisi égale à 1/2.

6. Un comparateur avec circuit de verrouillage selon l'une quelconque des revendications 3 à 5, caractérisé en ce qu'un étage amplificateur ($T_{18}$, $T_{19}$) est prévu sur chaque sortie de l'étage différentiel ($T_{16}$, $T_{17}$).

7. Un comparateur avec circuit de verrouillage selon l'une quelconque des revendications 3 à 6, caractérisé en ce que les résistances de charges ($R_3$) du circuit de simulation sont égales à ε fois et les résistances de charge du circuit de verrouillage avec ε # 1 et > 1.

8. Un comparateur avec circuit de verrouillage selon l'une quelconque des revendications 3 à 7, caracérisé en ce qu'il comporte une diode ($D_3$) montée entre la masse et la base du transistor intermédiaire ($T_{12}$) pour éviter le blocage du circuit de polarisation (3) lors de la mise en marche.

9. Un comparateur avec circuit de verrouillage selon l'une quelconque des revendications 3 à 8, caractérisé en ce qu'il comporte un condensateur ($C_1$) monté entre masse et base du transistor intermédiaire ($T_{12}$) pour assurer la stabilité du circuit de polarisation.

10. Un comparateur avec circuit de verrouillage selon l'une quelconque des revendications 3 à 9, caractérisé en ce que l'étage différentiel ($T_{16}$, $T_{17}$) comporte des résistances ($R_8$) de contre-réaction d'émetteur pour assurer la stabilité du circuit de polarisation.

11. Un convertisseur analogique-numérique comportant $2^n$-1 étages comparateurs comprenant chacun au moins un circuit de comparaison, un circuit de verrouillage constitué par au moins deux transistors montés en bascule bistable à rebouclage direct dont chacune des sorties est reliée à une résistance de charge et à un transistor de liaison avec un circuit antisaturation monté en parallèle sur chaque ensemble résistance de charge-transistor de liaison et un circuit d'encodage, un circuit de polarisation selon l'une quelconque des revendications 3 à 10, commun à tous les étages comparateurs fournissant entre la base des transistors de liaison et la base des transistors antisaturation correspondants une différence de potentiel évitant la saturation des transistors montés en bascule bistable.

**Patentansprüche**

1. Vergleicher mit Einrastschaltung in Bipolartechnologie und mit mindestens einem Vergleicherkreis (1) und einer Einrastschaltung (2), die aus mindestens zwei Transistoren ($T_4$, $T_5$) besteht, die als bistabiles Kippglied mit direkter Rückschleifung geschaltet sind und von denen jeder Ausgang mit einem Lastwiderstand ($R_1$) und einem Verbindungstransistor ($T_6$, $T_7$) verbunden ist, dadurch gekennzeichnet, dass er weiterhin eine Sättigungsverhinderungsschaltung ($T_8$, $T_9$), die parallel zur Baugruppe aus dem Lastwiderstand und dem Verbindungstransistor geschaltet ist, und einen Polarisationskreis (3) enthält, der zwischen der Basis des Verbindungstransistors ($T_6$, $T_7$) und der entsprechenden Sättigungsverhinderungsschaltung ($T_8$, $T_9$) eine Potentialdifferenz liefert, die die Sättigung der als bistabiles Kippglied geschalteten Transistoren ($T_4$, $T_5$) verhindert.

2. Vergleicher mit der Einrastschaltung nach Anspruch 1, dadurch gekennzeichnet, dass die Sättigungsverhinderungsschaltung aus einem Bipolartransistor ($T_8$, $T_9$) gebildet wird, dessen Kollektor mit dem Kollektor des Verbindungstransistors, dessen Basis mit dem Polarisierungskreis und dessen Emitter mit einem der Ausgänge des Kippglieds verbunden ist.

3. Vergleicher mit Einrastschaltung nach einem der Ansprüche 1 und 2, dadurch gekennzeichnet, dass der Polarisierungskreis (3) aus einer Simulierungsschaltung ($T'_4$, $T'_8$, $T'_6$, $T'_7$) gebildet wird, die den leitenden Teil der Einrastschaltung widerspiegelt, die mit der Sättigungsverhinderungsschaltung versehen ist, an die eine die Sättigung verhindernde Potentialdifferenz angelegt wird, und deren Transistor, der die Hälfte des bistabilen Kippglieds bildet, über einen genau gleichen Zwischentransistor ($T_{12}$) durch eine Stromquelle (I+J) polarisiert wird, deren Wert gleich dem der Stromquelle ist, die die Einrastschaltung des Vergleichers polarisiert, und dadurch, dass der Basisstrom des Transistors ($T'_4$) der die Hälfte des bistabilen Kippglieds bildet, der so gewählt ist, dass er diesen Transistor genau am Beginn der Sättigung oder ausserhalb davon hält, nach Durchlauf durch einen Stromspiegel (M) mit dem Basisstrom des Zwischentransistors ($T_{12}$) verglichen wird, wobei jede Stromdifferenz eine Spannungsänderung erzeugt, die an eine Differenzierungsstufe gesandt wird, die als Ausgangssignal die genannte sättigungsverhindernde Potentialdifferenz ausgibt, um den Basisstrom des Transistors ($T'_4$), der die Hälfte des bistabilen Kippglieds bildet, wieder ins Gleichgewicht zu bringen.

4. Vergleicher mit Einrastschaltung nach Anspruch 3, dadurch gekennzeichnet, dass der Stromspiegel (M) einen Verstärkungsfaktor k aufweist, der kleiner als 1 ist.

5. Vergleicher mit Einrastschaltung nach Anspruch 4, dadurch gekennzeichnet, dass der Verstärkungsfaktor k gleich 1/2 gewählt wird.

6. Vergleicher mit Einrastschaltung nach einem der Ansprüche 3 bis 5, dadurch gekennzeichnet, dass eine Verstärkerstufe ($T_{18}$, $T_{19}$) an jedem Ausgang der Differenzierungsstufe ($T_{16}$, $T_{17}$) vorgesehen ist.

7. Vergleicher mit Einrastschaltung nach einem der Ansprüche 3 bis 6, dadurch gekennzeichnet, dass die Lastwiderstände ($R_3$) der Simulierungsschaltung gleich einem εfachen Vielfachen der Lastwiderstände der Einrastschaltung sind, wobei ε = 1 oder > 1 ist.

8. Vergleicher mit Einrastschaltung nach einem der Ansprüche 3 bis 7, dadurch gekennzeichnet, dass er eine Diode ($D_3$) enthält, die zwischen der Masse und der Basis des Zwischentransistors ($T_{12}$) geschaltet ist, um die Blockierung des Polarisierungskreises (3) bei der Inbetriebnahme zu verhindern.

9. Vergleicher mit Einrastschaltung nach einem der Ansprüche 3 bis 8, dadurch gekennzeichnet, dass er einen Kondensator ($C_1$) enthält, der zwischen der Masse und der Basis des Zwischentransistors ($T_{12}$) geschaltet ist, um die Stabilität des Polarisierungskreises zu gewährleisten.

10. Vergleicher mit Einrastschaltung nach einem der Ansprüche 3 bis 9, dadurch gekennzeichnet, dass die Differenzierungsstufe ($T_{16}$, $T_{17}$) Emitter-Gegenkopplungswiderstände ($R_8$) enthält, um die Stabilität des Polarisierungskreises zu gewährleisten.

11. Analog-Digitalwandler mit $2^n$-1 Vergleicherstufen, mit je mindestens einem Vergleicherkreis, einer Einrastschaltung, die aus mindestens zwei Transistoren besteht, die als bistabiles Kippglied mit direkter Rückschleifung geschaltet sind, und von denen jeder Ausgang mit einem Lastwiderstand und einem Verbindungstransistor verbunden ist, wobei die Einrastschaltung mit einer Sättigungsverhinderungsschaltung versehen ist, die zu jeder aus Lastwiderstand und Verbindungstransistor bestehenden Baugruppe parallel geschaltet ist, und einem Kodierungskreis, wobei ein Polarisierungskreis nach einem der Ansprüche 3 bis 10, der allen Vergleicherstufen gemein ist, zwischen der Basis der Verbindungstransistoren und der Basis der entsprechenden Sättigungsverhinderungstransistoren eine Potentialdifferenz liefert, die die Sättigung der als bistabiles Kippglied geschalteten Transistoren verhindert.

### Claims

1. Comparator with a latch circuit in bipolar technology and comprising at least one comparing circuit (1) and a latch circuit (2) formed of at least two transistors ($T_4$, $T_5$) mounted as a bistable circuit with direct feedback whereof each output is connected to a load resistor ($R_1$) and to a connection transistor ($T_6$, $T_7$), characterized in that it further comprises an antisaturation circuit ($T_8$, $T_9$) mounted in parallel on each load resistor-connection transistor unit, and a polarizing circuit (3) supplying between the base of the connection transistor ($T_6$, $T_7$) and the corresponding antisaturation circuit ($T_8$, $T_9$) a potential difference avoiding the saturation of the transistors ($T_4$, $T_5$) mounted to form a bistable circuit.

2. Comparator with a latch circuit according to claim 1, characterized in that the antisaturation circuit is formed by a bipolar transistor ($T_8$, $T_9$) the collector of which is connected to the collector of the connection transistor, the base to the polarizing circuit and the emitter to one of the outputs of the bistable circuit.

3. Comparator with a latch circuit according to any of claims 1 and 2, characterized in that the polarizing circuit (3) is formed by a simulating circuit ($T'_4$, $T'_8$, $T'_6$, $T'_7$) reproducing the conductive portion of the latch circuit provided with the antisaturation circuit whereto the potential difference avoiding the saturation is applied and whereof the transistor forming half of the bistable circuit is polarized through an identical intermediate transistor ($T_{12}$) by a current source (I+J) of a value equal to that of the current source polarizing the latch circuit of the comparator, and in that a base current of the transistor ($T'_4$) forming half of the bistable circuit, as selected for maintaining said transistor just at the beginning of saturation or out of saturation, is compared to the base current of the intermediate transistor ($T_{12}$) after passing through a current mirror (M), any current difference generating a voltage variation supplied to a differential stage the output of which supplies said potential difference avoiding the saturation to re-establish the base current of the transistor ($T'_4$) forming half of the bistable circuit.

4. Comparator with a latch circuit according to claim 3, characterized in that the current mirror (M) has a gain k smaller than 1.

5. Comparator with a latch circuit according to claim 4, characterized in that the gain k is selected equal to 1/2.

6. Comparator with a latch circuit according to any of claims 3 to 5, characterized in that an amplifier stage ($T_{18}$, $T_{19}$) is provided on each output of the differential stage ($T_{16}$, $T_{17}$).

7. Comparator with a latch circuit according to any of claims 3 to 6, characterized in that the load resistors ($R_3$) of the simulating circuit are equal to the ε fold load resistors of the latch circuit with ε = 1 and > 1.

8. Comparator with a latch circuit according to any of claims 3 to 7, characterized in that it comprises a diode ($D_3$) mounted between ground and the base of the intermediate transistor ($T_{12}$) to avoid the blocking of the polarizing circuit (3) upon initiation of operation.

9. Comparator with a latch circuit according to any of claims 3 to 8, characterized in that it comprises a capacitor ($C_1$) mounted between ground and the base of the intermediate transistor ($T_{12}$) to ensure the stability of the polarizing circuit.

10. Comparator with a latch circuit according to any of claims 3 to 9, characterized in that the differential stage ($T_{16}$, $T_{17}$) comprises negative feedback resistors ($R_8$) for ensuring the stability of the polarizing circuit.

11. Analog-digital converter comprising $2^n$-1 comparator stages each comprising at least one comparing circuit, a latch circuit formed by at least two transistors mounted as a bistable circuit with direct feedback and having each of its outputs connected to a load resistor and to a connection transistor, with a antisaturation circuit mounted in parallel on each load resistor-connection transistor unit, and an encoding circuit, a polarizing circuit according to any of claims 3 to 10 common to all the comparator stages supplying between the base of the connection transistors and the base of the corresponding antisaturation transistors a potential difference avoiding the saturation of the transistors mounted as a bistable circuit.

# FIG_1

ART ANTERIEUR

FIG_2

0 161 973